# FASCICULE DE BREVET EUROPEEN

(11) **EP 0 693 791 B1**
(45) Date de publication et mention de la délivrance du brevet: **23.09.1998**
(21) Numéro de dépôt: 95401724.0
(22) Date de dépôt: 19.07.1995
(51) Int. Cl.: H01L 43/08, G01R 33/09, G11B 5/39

(54) **Capteur à magnétorésistance multicouche autopolarisée**
Magnetwiderstands-Sensor mit selbstpolarisiertem Mehrschichtsystem
Auto-polarized multilayer magnetoresistive transducer

(30) Priorité: 21.07.1994 FR 9409038
(43) Date de publication de la demande: 24.01.1996
(73) Titulaire: COMMISSARIAT A L'ENERGIE ATOMIQUE, 75015 Paris Cédex 15 (FR)
(72) Inventeur: Mouchot, Jean, F-38000 Grenoble (FR); Dieny, Bernard, F-38170 Seyssinet (FR)
(74) Mandataire: Dubois-Chabert, Guy

(56) Documents cités:
- EP-A- 0 529 959
- DE-A- 4 243 357
- US-A- 4 713 708
- US-A- 4 816 948
- PATENT ABSTRACTS OF JAPAN vol. 16, no. 189 (P-1348) 08 Mai 1992 & JP-A-04 024 575 (NEC CORP.) 28 Janvier 1992
- PATENT ABSTRACTS OF JAPAN vol. 15, no. 106 (E-1044) 13 Mars 1991 & JP-A-02 312 287 (NEC CORP.) 27 Décembre 1990
- PATENT ABSTRACTS OF JAPAN vol. 18, no. 35 (E-1494) 19 Janvier 1994 & JP-A-05 267 747 (FUJITSU LIMITED) 15 Octobre 1993

## Description

### Domaine technique

La présente invention a pour objet un capteur à magnétorésistance multicouche autopolarisée. Elle s'applique particulièrement à la réalisation de têtes de lecture pour enregistrement magnétique, de capteurs magnétorésistifs pour systèmes de type codeur et de capteurs magnétorésistifs pour la mesure de courants.

### Etat de la technique antérieure

Un élément magnétorésistant est un élément qui voit sa résistance varier en fonction du champ magnétique qui lui est appliqué. Pour mesurer cette résistance, soit on fait circuler un courant dans la magnétorésistance et l'on mesure soit la tension aux bornes de l'élément, soit on impose une différence de potentiel aux bornes de l'élément et l'on mesure la variation d'intensité du courant.

On connaît des capteurs magnétorésistifs pour lesquels la direction du champ à mesurer est dirigée perpendiculairement à l'axe longitudinal de l'élément magnétorésistant et d'autres où le champ est parallèle à cet axe longitudinal. La présente invention se rapporte à ce second cas.

Certaines magnétorésistances sont constituées par un seul matériau et sont dites "monolithiques". D'autres sont constituées par un empilement de couches magnétiques séparées par des couches non-magnétiques. Elles sont dites "multicouches". Dans certaines magnétorésistances multicouches, il est possible de changer l'orientation relative des aimantations dans des couches magnétiques successives. On observe alors une variation de résistance suivant que les couches magnétiques sont orientées antiparallèlement ou parallèlement les unes aux autres.

Dans la grande majorité des systèmes connus, la résistance électrique est maximum pour une configuration d'alignement antiparallèle et minimum dans la configuration d'alignement parallèle.

Suivant l'épaisseur et la nature des couches magnétiques et non magnétiques, il est possible d'optimiser l'effet magnétorésistif.

Par ailleurs, il est avantageux, dans certains cas, de polariser l'élément magnétorésistif au moyen d'un champ magnétique statique, de sorte que la réponse électrique de cet élément magnétorésistif devient linéaire en fonction du champ à mesurer.

Le champ magnétique de polarisation est généralement appliqué de façon uniforme dans le plan de l'élément magnétorésistif.

Le document US-A-4 949 039 décrit ainsi un effet magnétorésistif obtenu avec des couches magnétiques séparées par des couches minces de matériaux non-magnétiques. Dans l'une des structures décrites, deux couches de matériaux ferromagnétiques doux sont découplées l'une de l'autre par une couche non magnétique et l'une des couches ferromagnétiques est piégée par anisotropie d'échange (couplage d'échange avec une quatrième couche d'un matériau antiferromagnétique, FeMn par exemple). Ce document spécifie que les matériaux employés doivent être tels qu'une diffusion dépendante du spin doit se produire à l'interface entre le matériau magnétique et le matériau non-magnétique.

L'article de H. Yamamoto et T. Shinjo publié dans la revue IEEE Translation Journal on Magnetics in Japan, vol. 7, n°9, Septembre 1992, et intitulé "Magnetoresistance of Multilayers", p. 674-684, décrit des structures magnétiques multicouches métalliques. Elles sont essentiellement constituées :
- de métaux magnétiques à base de fer, de nickel, de cobalt ou de l'un quelconque des alliages formés à partir de ces trois éléments,
- de métaux de transition non ferromagnétiques ou de métaux nobles tels que, par exemple, le cuivre, le chrome, l'argent, l'or, le molybdène, le ruthénium.

Bien que donnant satisfaction à certains égards, tous ces dispositifs présentent l'inconvénient de nécessiter des moyens de polarisation pour obtenir une réponse linéaire. La présente invention a justement pour but de remédier à cet inconvénient.

### Exposé de l'invention

A cette fin, l'invention propose un capteur dans lequel l'élément sensible au champ magnétique est polarisé par le courant même circulant dans la magnétorésistance. La réponse du capteur est donc automatiquement linéaire, sans qu'il soit besoin d'ajouter des moyens pour créer un champ de polarisation.

De façon précise, la présente invention a donc pour objet un capteur à magnétorésistance multicouche autopolarisée comprenant, de manière connue :
- un élément sensible au champ magnétique comprenant un empilement de couches alternativement magnétiques et non magnétiques, cet élément ayant une direction longitudinale orientée parallèlement au champ magnétique à mesurer,
- des moyens pour faire passer un courant électrique à travers l'élément dans la direction longitudinale,
- des moyens de mesure de la résistance de l'élément,
ce capteur étant caractérisé par le fait que l'élément sensible au champ magnétique comprend un empilement d'au moins une première couche ferromagnétique, encadrée par une seconde et une troisième couches ferromagnétiques séparées de la première couche par une première et une deuxième couches non magnétiques conductrices, la première couche ferromagnétique présentant une aimantation qui est bloquée et dirigée dans la direction longitudinale, les deuxième et troisième couches présentant, en l'absence de champ magnétique à mesurer lorsque le courant électrique parcourt l'élément sensible, des aimantations sensiblement perpendiculaires à la direction longitudinale, l'aimantation dans la deuxième couche étant sensiblement de sens opposé à l'aimantation dans la troisième.

Dans une variante avantageuse, l'empilement comprend deux autres couches ferromagnétiques à aimantation longitudinale bloquée, ces autres couches associées à des couches non magnétiques conductrices encadrant l'empilement précédent.

De préférence, la ou les couche(s) ferromagnétique(s) à aimantation longitudinale est (sont) en alliage à base de fer et de cobalt, avec éventuellement un faible pourcentage de terres rares anisotropes comme par exemple Nd, Sm ou Tb.

Quant aux deuxième et troisième couches ferromagnétiques à aimantations de sens inverse perpendiculaires à la direction longitudinale, elles sont avanteugement en alliage ferromagnétique doux de métaux de transition tel qu'un alliage de fer, de nickel, ou de cobalt et, par exemple, en permalloy (Fe20Ni80). L'épaisseur de ces couches peut être comprise par exemple entre 1 et 10 nm.

De part et d'autre de l'empilement, l'élément peut comporter une alternance de couches ferromagnétiques d'aimantation longitudinale bloquée et de couches ferromagnétiques d'aimantation perpendiculaire comme les deuxième et troisième couches, ces différentes couches étant séparées par des couches non magnétiques conductrices.

Les couches non magnétiques conductrices sont, par exemple en cuivre, en argent ou en or. L'épaisseur de ces couches non magnétiques est suffisamment grande (par exemple entre 1 et 10 nm) pour que les couches ferromagnétiques à aimantations opposées soient considérées comme isolées magnétiquement ("libres"). Le blocage de l'aimantation de la ou des couche(s) ferromagnétique(s) à aimantation longitudinale peut être obtenu soit en choisissant un matériau de forte coercitivité, soit en associant à chaque couche ferromagnétique concernée une couche d'un matériau magnétique dur ou d'un matériau antiferromagnétique apte à introduire une anisotropie d'échange. On entend par matériau à forte coercitivité un matériau dont le champ coercitif est supérieur au champ à mesurer.

### Brève description des dessins

- la figure 1 montre une vue schématique d'un capteur selon l'invention ;
- la figure 2 montre la variation du champ magnétique de polarisation en fonction de l'éloignement par rapport au centre de l'élément ;
- la figure 3 montre la variation de la résistivité en fonction du champ magnétique longitudinal appliqué ;
- la figure 4 illustre un premier mode de réalisation de l'élément sensible au champ magnétique ;
- la figure 5 illustre un second mode de réalisation de l'élément sensible au champ magnétique ;
- la figure 6 illustre un troisième mode de réalisation de cet élément.

### Exposé détaillé de modes de réalisation

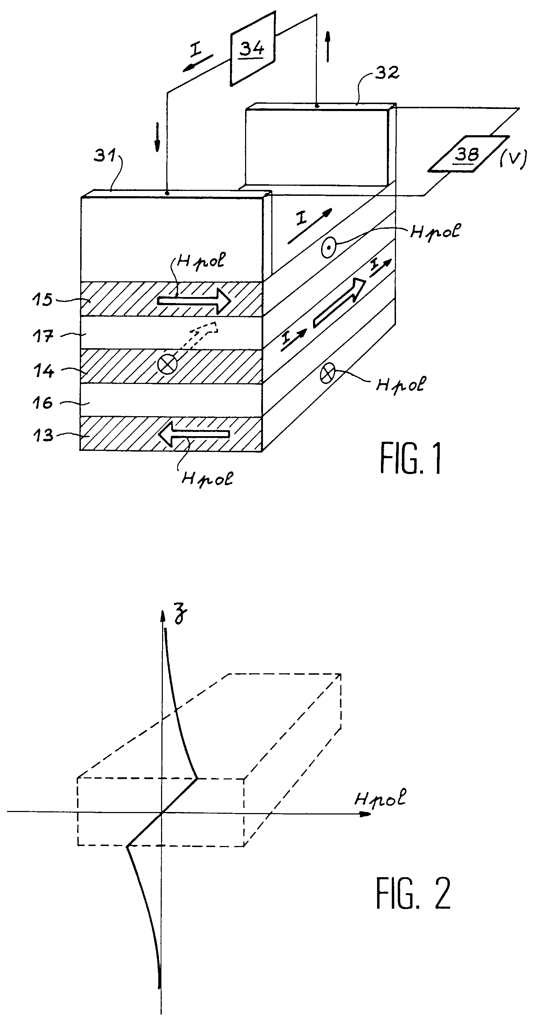

La figure 1 montre une vue en perspective d'un capteur selon l'invention avec une première couche ferromagnétique 14 présentant une aimantation longitudinale bloquée (représentée schématiquement par une flèche dirigée perpendiculairement au plan de la figure), une seconde couche ferromagnétique 13 avec une aimantation parallèle au plan de la figure et dirigée vers la gauche, une troisième couche ferromagnétique 15 avec une aimantation encore parallèle au plan de la figure mais dirigée vers la droite. Ces trois couches 13, 14 et 15 sont séparées les unes des autres par une première et une seconde couches non magnétiques respectivement 16 et 17. Ces couches sont conductrices de l'électricité et sont en métal.

Deux connexions 31 et 32 sont disposées à chaque extrémité de l'empilement et l'ensemble est relié à un générateur de courant 34 faisant circuler dans l'empilement un courant I.

Un appareil 38, du genre voltmètre, mesure la tension aux bornes de l'empilement, tension qui donne la valeur de la résistance de l'empilement si le courant I est maintenu constant.

La circulation du courant I produit un champ magnétique dont les lignes de champ sont approximativement des droites perpendiculaires au vecteur courant I et parallèles aux interfaces des couches. L'intensité de ce champ est donnée par le théorème d'Ampère, qui exprime que la circulation du champ le long d'un contour fermé est égal au courant traversant la surface délimitée par ce contour. On peut ainsi facilement montrer que ce champ d'autopolarisation créé par le courant est nul dans le plan médian de l'empilement et varie linéairement de part et d'autre de ce plan.

Par exemple, avec des couches 13, 14, 15 d'épaisseur 5 nm et des couches 16 et 17 d'épaisseur 2,5 nm, on trouve que le champ produit par un courant de 10⁷ A/cm² est de 1 kA/m à une distance de 10 nm du plan central de l'empilement.

Ce champ constitue un champ de polarisation intrinsèque à l'élément sensible.

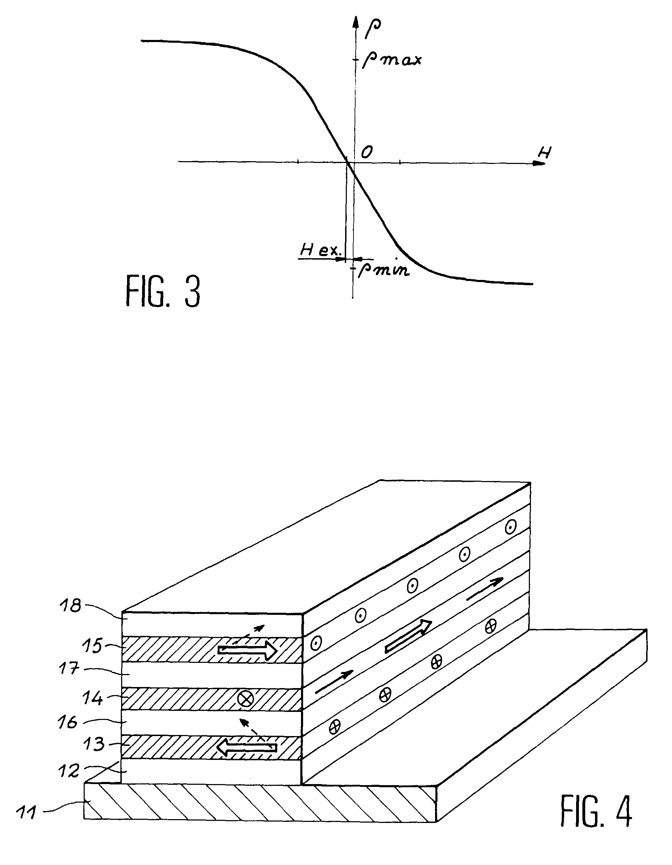

La figure 2 donne la variation d'intensité de ce champ Hpol (porté en abscisses) en fonction de l'éloignement z par rapport au plan médian de la structure (éloignement porté en ordonnées) . Le champ est nul dans le plan médian et augmente de part et d'autre de celui-ci, linéairement tant que l'on est à l'intérieur de l'empilement. A l'extérieur, le champ décroît pour s'annuler à l'infini.

Sous l'effet du champ de polarisation Hpol, les aimantations des couches 13 et 15 s'orientent sensiblement perpendiculairement à la direction d'aimantation de la couche ferromagnétique bloquée 14. De plus, les aimantations des couches 13 et 15 sont antiparallèles.

L'application d'un champ magnétique à mesurer tend à faire tourner les aimantations des couches 13 et 15 dans la direction du champ appliqué ce qui change l'orientation relative des aimantations des couches 14 et 15 et modifie par là même la résistivité ρ de la structure.

La figure 3 montre un exemple de variation de la résistivité ρ (portée en ordonnées) en fonction du champ magnétique appliquée H, porté en abscisses. On voit que cette variation est linéaire dans une certaine plage de champ.

La courbe ρ(H) peut ne pas passer par l'origine et être décalée d'un champ Hex, comme c'est le cas sur la figure 3. Ce décalage correspond soit à un éventuel résidu de couplage ferromagnétique (voire antiferromagnétique) entre couches, soit à des effets d'anisotropie de forme.

Les figures 4, 5 et 6 illustrent trois modes particuliers de réalisation d'un capteur selon l'invention. Sur ces figures, les connexions électriques, la source d'alimentation en courant et les moyens de mesure de la résistance ne sont pas représentés.

Sur la figure 4 on voit un substrat 11, une couche tampon 12, en tantale par exemple, et les couches 13, 14, 15, 16 et 17 déjà représentées sur la figure 1. Par ailleurs, une couche de protection 18, en tantale ou en TiW par exemple, est déposée sur l'ensemble.

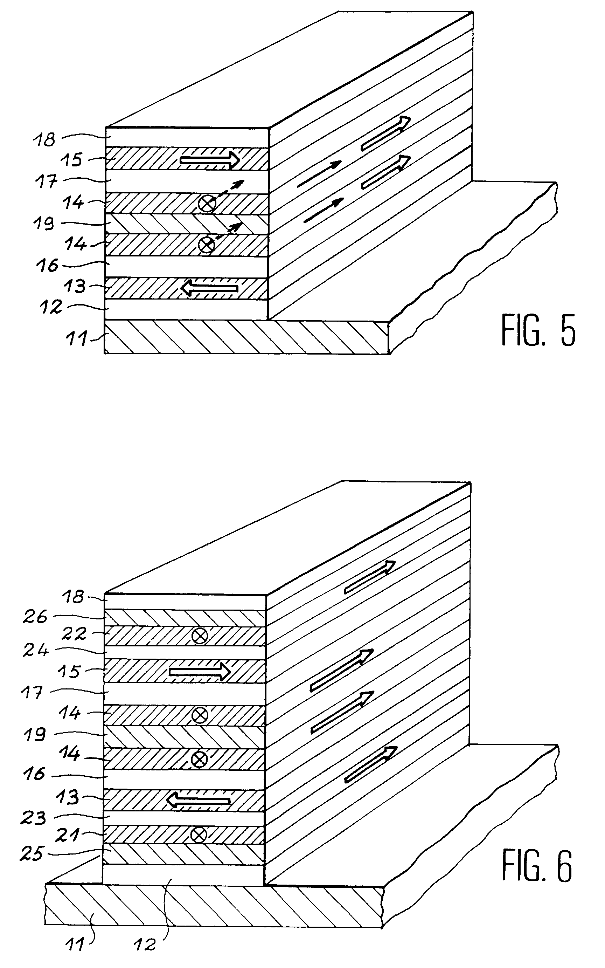

Dans la variante de la figure 5, la couche ferromagnétique centrale à forte coercitivité est constituée par une couche magnétique douce 14, en permalloy par exemple, cette couche ayant son aimantation bloquée soit par anisotropie d'échange avec une couche antiferromagnétique de type MnFe, NiO ou TbCo, soit par un couplage direct avec un matériau dur (type alliage à base de NdCo, SmCo, NdFeB ...). Cette couche supplémentaire est référencée 19. Sur la figure 5, la couche 14 est divisée en deux parties entre lesquelles est disposée la couche antiferromagnétique ou la couche magnétique dure 19.

On retrouve par ailleurs toutes les autres couches 12 à 18 et le substrat 11.

Dans l'exemple de la figure 6, on cherche à augmenter l'effet recherché, à savoir la variation de résistivité. La structure décrite à propos de la figure 5 est conservée mais étoffée en haut et en bas. Des quatrième et cinquième couches ferromagnétiques 21 et 22 sont déposées. Elles sont, par exemple, à base de fer, nickel ou cobalt (et avantageusement riche en cobalt). Leur aimantation est bloquée dans la direction du champ à mesurer. Ce bloquage peut être assuré en utilisant des matériaux à forte coercitivité, comme pour la figure 1 (le champ coercitif sera largement supérieur au champ à mesurer) ou par anisotropie d'échange avec des couches 25 et 26, comme pour la figure 5, ces couches étant en matériau antiferromagnétique, du type FeMn par exemple. Les couches 21 et 22 sont séparées des couches magnétiques 13 et 15 par deux couches de matériau non magnétique 23 et 24 -en argent par exemple- d'une épaisseur telle qu'il n'y ait pas ou pratiquement pas de couplage magnétique entre les couches 15 et 22 ou 13 et 21.

Une couche de protection 18 peut encore recouvrir la structure. Cette couche peut être en Ta ou en TiW par exemple.

Dans cet exemple, les couches 21, 14 et 22 sont orientées parallèlement. Seules les couches ferromagnétiques 13 et 15 sont libres de tourner en l'absence de courant à mesurer. En présence de courant, mais sans champ appliqué, les couches 13 et 15 s'orientent sensiblement à 90° de la direction d'aimantation des couches 14, 21 et 22. Le champ magnétique à mesurer désoriente l'aimantation des couches 13 et 15 en modifiant par là la résistivité de la structure.

Comme décrit dans le brevet EP 0 529 959, il peut être avantageux de déposer à chaque interface entre les couches de matériau non magnétique et les couches ferromagnétiques 13, 14 et 15 ou à certaines de ces interfaces, une couche ultra-mince d'un matériau riche en cobalt (Co₉₀Fe₁₀ par exemple) afin d'augmenter l'effet magnétorésistif recherché. Cette variante peut être appliquée dans tous les cas et en particulier dans celles des figures 1, 4 et 5.

## Revendications

1. Capteur à magnétorésistance multicouche autopolarisée comprenant :
- un élément sensible au champ magnétique comprenant un empilement de couches alternativement magnétiques et non magnétiques, cet élément ayant une direction longitudinale orientée parallèlement au champ magnétique à mesurer,
- des moyens (34) pour faire passer un courant électrique à travers l'élément, dans la direction longitudinale,
- des moyens (38) de mesure de la résistance de l'élément,
ce capteur étant caractérisé par le fait que l'élément sensible au champ magnétique comprend un empilement d'au moins une première couche ferromagnétique (14), encadrée par une seconde (13) et une troisième (15) couches ferromagnétiques séparées de la première couche (14) par une première (16) et une seconde (17) couches non magnétiques conductrices, la première couche ferromagnétique (14) présentant une aimantation qui est bloquée et dirigée dans la direction longitudinale, les deuxièmes et troisièmes couches (13, 15) présentant, en l'absence de champ magnétique à mesurer lorsque le courant électrique parcourt l'élément sensible, des aimantations sensiblement perpendiculaires à la direction longitudinale sous l'effet du champ magnétique de polarisation engendré par le courant traversant l'élément, l'aimantation dans la deuxième couche (15) étant sensiblement de sens opposé à l'aimantation dans la troisième couche (15).

2. Capteur selon la revendication 1, caractérisé par le fait que l'élément sensible au champ magnétique comprend, en outre, une quatrième couche ferromagnétique (21) disposée sous la deuxième couche ferromagnétique (13) et séparée de celle-ci par une troisième couche non magnétique conductrice (23) ainsi qu'une cinquième couche ferromagnétique (22) disposée au-dessus de la troisième couche ferromagnétique (15) et séparée de celle-ci par une quatrième couche non magnétique conductrice (24), ces quatrième et cinquième couches ferromagnétiques (21, 22) ayant une aimantation longitudinale bloquée parallèle à l'aimantation de la première couche ferromagnétique (14).

3. Capteur selon les revendications 1 ou 2, caractérisé par le fait que la (les) couche(s) ferromagnétique(s) à aimantation longitudinale est (sont) (14, 21, 22) en alliage à base de fer et de cobalt.

4. Capteur selon la revendication 3, caractérisé par le fait que l'alliage constituant la (les) couche(s) ferromagnétique(s) à aimantation longitudinale (14, 21, 22) comprend en outre un faible pourcentage de terres rares anisotropes.

5. Capteur selon la revendication 1, caractérisé par le fait que les deuxième et troisième couches ferromagnétiques (13, 15) sont en alliage ferromagnétique doux de métaux de transition.

6. Capteur selon la revendication 1, caractérisé par le fait que les couches non magnétiques conductrices (16, 17) sont en matériau pris dans le groupe constitué par Cu, Ag, Au.

7. Capteur selon la revendication 1 ou 2, caractérisé par le fait que la (les) couche(s) ferromagnétiques à aimantation longitudinale bloquée (14, 21, 22) a (ont) un champ coercitif supérieur au champ à mesurer.

8. Capteur selon la revendication 1 ou 2, caractérisé par le fait que la (les) couche(s) ferromagnétique (s) à aimantation longitudinale bloquéée (14, 21, 22) est (sont) en matériau magnétique doux et est (sont) en contact avec une couche antiferromagnétique (19, 26, 25) induisant une anisotropie d'échange.

9. Capteur selon la revendication 9, caractérisé par le fait que le matériau antiferromagnétique est pris dans le groupe constitué par MnFe, NiO, TbCo, DyCo.

10. Capteur selon la revendication 1 ou 2, caractérisé par le fait que la (les) couche(s) ferromagnétique(s) à aimantation longitudinale bloquée (14, 21, 22) est (sont) en matériau magnétique doux et est (sont) au contact avec une couche en matériau magnétique dur.

11. Capteur selon la revendication 11, caractérisée par le fait que le matériau dur est pris dans le groupe constitué par NdCo, SmCo, NdFeB.

12. Capteur selon la revendication 9 ou 11, caractérisé en ce que la première couche ferromagnétique (14) est divisée en deux parties entre lesquelles est disposée la couche antiferromagnétique ou la couche magnétique dure.

13. Capteur selon l'une quelconque des revendications 1 à 12, caractérisé par le fait qu'au moins une couche ferromagnétique (13, 14, 15) est séparée de la couche non magnétique adjacente (16, 17) par une couche magnétique ultramince riche en cobalt.

14. Capteur selon l'une quelconque des revendications 1 à 13, caractérisé par le fait qu'il comprend une couche de protection (18) recouvrant l'empilement.

15. Capteur selon l'une quelconque des revendications 1 à 14, caractérisé par le fait que l'empilement est disposé sur un substrat (11).

16. Capteur selon la revendication 15, caractérisé par le fait qu'il comprend une couche tampon (12) entre l'empilement et le substrat (11).

## Patentansprüche

1. Magnetwiderstands-Sensor mit selbstpolarisiertem Mehrschichtsystem, umfassend:
- ein magnetfeld-sensibles Element mit einem Stapel von abwechselnd magnetischen und unmagnetischen Schichten, wobei dieses Element eine zu dem zu messenden Magnetfeld parallele Längsrichtung hat,
- Einrichtungen (34), um einen elektrischen Strom in Längsrichtung durch das Element fließen zu lassen,
- Meßeinrichtungen (38) für den Widerstand des Elements,
wobei dieser Sensor **dadurch gekennzeichnet** ist, daß das magnetfeld-sensible Element einen Stapel aus wenigstens einer ersten ferromagnetischen Schicht (14) umfaßt, eingerahmt durch eine zweite (13) und dritte (15) ferromagnetische Schicht, getrennt von der ersten Schicht (14) durch eine erste (16) und zweite (17) unmagnetische leitende Schicht, wobei die erste ferromagnetische Schicht (14) eine blockierte und in Längsrichtung orientierte Magnetisierung aufweist, die zweite und die dritte Schicht (13, 15) bei Fehlen des zu messenden Magnetfelds, wenn der elektrische Strom das empfindliche Element durchfließt, Magnetisierungen aufweisen, die unter der Wirkung des Polarisationsmagnetfelds, erzeugt durch den das Element durchfließenden Strom, im wesentlichen senkrecht zu der Längsrichtung sind, wobei die Magnetisierung der zweiten Schicht (15) im wesentlichen die zur Magnetisierung der dritten Schicht (15) umgekehrte Richtung aufweist.

2. Sensor nach Anspruch 1, dadurch gekennzeichnet, daß das magnetfeld-sensible Element außerdem eine vierte ferromagnetische Schicht (21) umfaßt, angeordnet unter der zweiten ferromagnetischen Schicht (13) und von dieser getrennt durch eine dritte unmagnetische leitende Schicht (23), sowie eine fünfte ferromagnetische Schicht (22), angeordnet über der dritten ferromagnetischen Schicht (15) und von dieser getrennt durch eine vierte unmagnetische leitende Schicht (24), wobei diese vierte und fünfte ferromagnetische (21, 22) Schicht eine zur Magnetisierung der ersten magnetischen Schicht (14) parallele blockierte Längsmagnetisierung aufweist.

3. Sensor nach einem der Ansprüche 1 oder 2, dadurch gekennzeichnet, daß die ferromagnetische(n) Schicht(en) mit Längsmagnetisierung (14, 21, 33) aus einer Legierung auf Eisen- und Kobaltbasis ist (sind).

4. Sensor nach Anspruch 3, dadurch gekennzeichnet, daß die die ferromagnetische(n) Schicht(en) bildende Legierung mit Längsmagnetisierung (14, 21, 22) außerdem einen kleinen Prozentsatz anisotroper Seltenerden enthält.

5. Sensor nach Anspruch 1, dadurch gekennzeichnet, daß die zweite und die dritte ferromagnetische Schicht (13, 15) aus einer weichen ferromagnetischen Legierung aus Übergangsmetallen sind.

6. Sensor nach Anspruch 1, dadurch gekennzeichnet, daß die unmagnetischen leitenden Schichten (16, 17) aus einem Material aus der Gruppe sind, die durch Cu, Ag, Au gebildet wird.

7. Sensor nach Anspruch 1 oder 2, dadurch gekennzeichnet, daß die ferromagnetische(n) Schicht(en) mit blockierter Längsmagnetisierung (14, 21, 22) ein stärkeres Koerzitiv-Magnetfeld als das zu messende Magnetfeld aufweißt (aufweisen).

8. Sensor nach Anspruch 1 oder 2, dadurch gekennzeichnet, daß die ferromagnetische(n) Schicht(en) mit blockierter Längsmagnetisierung (14, 21, 22) aus weichem magnetischem Material ist (sind) und in Kontakt ist (sind) mit einer eine Wechsel- bzw. Austauschanisotropie induzierenden antiferromagnetischen Schicht (19, 26, 25).

9. Sensor nach Anspruch 8, dadurch gekennzeichnet, daß das antiferromagnetische Material ausgewählt wird aus der Gruppe, die durch MnFe, NiO, TbCo, DyCo gebildet wird.

10. Sensor nach Anspruch 1 oder 2, dadurch gekennzeichnet, daß die ferromagnetische(n) Schicht(en) mit blockierter Längsmagnetisierung (14, 21, 22) aus weichem magnetischen Material ist (sind) und in Kontakt mit einer Schicht aus hartem magnetischem Material ist (sind).

11. Sensor nach Anspruch 10, dadurch gekennzeichnet, daß das harte magnetische Material ausgewählt wird aus der Gruppe, die durch NdCo, SmCo, NdFeB gebildet wird.

12. Sensor nach Anspruch 9 oder 11, dadurch gekennzeichnet, daß die erste ferromagnetische Schicht (14) in zwei Teile geteilt ist, zwischen denen die antiferromagnetische Schicht oder die harte magnetische Schicht angeordnet ist.

13. Sensor nach Anspruch 1 bis 12, dadurch gekennzeichnet, daß wenigstens eine ferromagnetische Schicht (13, 14, 15) von der angrenzenden unmagnetischen Schicht (16, 17) durch eine ultradünne kobaltreiche magnetische Schicht getrennt ist.

14. Sensor nach Anspruch 1 bis 13, dadurch gekennzeichnet, daß er eine den Stapel bedeckende Schutzschicht (18) umfaßt.

15. Sensor nach einem der Ansprüche 1 bis 14, dadurch gekennzeichnet, daß der Stapel auf einem Substrat (11) angeordnet ist.

16. Sensor nach Anspruch 15, dadurch gekennzeichnet, daß er eine Pufferschicht (12) zwischen dem Stapel und dem Substrat (11) umfaßt.

## Claims

1. Self-biased multilayer magnetoresistance sensor comprising:
- an element sensitive to the magnetic field comprising a stack of alternately magnetic and non-magnetic layers, said element having a longitudinal direction oriented parallel to the magnetic field to be measured,
- means (34) for passing an electrical current through the element in the longitudinal direction,
- means (38) for measuring the resistance of the element,
said sensor being characterized in that the element sensitive to the magnetic field has a stack of at least one first ferromagnetic layer (14) surrounded by a second (13) and a third (15) ferromagnetic layers separated from the first layer (14) by a first (16) and a second (17) conductive, non-magnetic layers, the first ferromagnetic layer (14) having a magnetization which is blocked and directed in the longitudinal direction, the second and third layers (13, 15) having, in the absence of a magnetic field to be measured when the electrical current traverses the sensitive element, magnetization substantially perpendicular to the longitudinal direction under the effect of the magnetic polarization field produced by the current traversing the element, the magnetization in the second layer (15) being substantially of the opposite sense to the magnetization in the third layer (15).

2. Sensor according to claim 1, characterized in that the element sensitive to the magnetic field also has a fourth ferromagnetic layer (21) placed beneath the second ferromagnetic layer (13) and separated therefrom by a third conductive, non-magnetic layer (23) and a fifth ferromagnetic layer (22) placed above the third ferromagnetic layer (15) and separated therefrom by a fifth conductive, non-magnetic layer (24), said fourth and fifth ferromagnetic layers (21, 22) having a longitudinal magnetization blocked parallel to the magnetization of the first ferromagnetic layer (14).

3. Sensor according to claim 1 or 2, characterized in that the ferromagnetic layer or layers with longitudinal magnetization (14, 21, 22) are of an alloy based on iron and cobalt.

4. Sensor according to claim 3, characterized in that the alloy constituting the ferromagnetic layer or layers with longitudinal magnetization (14, 21, 22) also has a low percentage of anisotropic rare earths.

5. Sensor according to claim 1, characterized in that the second and third ferromagnetic layers (13, 15) are of soft transition metal ferromagnetic alloy.

6. Sensor according to claim 1, characterized in that the conductive, non-magnetic layers (16, 17) are chosen from Cu, Ag and and Au.

7. Sensor according to claim 1 or 2, characterized in that the ferromagnetic layer or layers with blocked longitudinal magnetization (14, 21, 22) has a coercive field higher than the field to be measured.

8. Sensor according to claim 1 or 2, characterized in that the ferromagnetic layer or layers with blocked longitudinal magnetization (14, 21, 22) is of soft magnetic material and in contact with an antiferromagnetic layer (19, 26, 25) inducing an exchange anisotropy.

9. Sensor according to claim 8, characterized in that the antiferromagnetic material is chosen from among MnFe, NiO, TbCo and DyCo.

10. Sensor according to claim 1 or 2, characterized in that the ferromagnetic layer or layers with blocked longitudinal magnetization (14, 21, 22) is of soft magnetic material and in contact with a hard magnetic material layer.

11. Sensor according to claim 9, characterized in that the hard material is chosen from among NdCo, SmCo, and NdFeB.

12. Sensor according to claim 9 or 11, characterized in that the first ferromagnetic layer (14) is subdivided into two portions between which is positioned the antiferromagnetic layer or the hard magnetic layer.

13. Sensor according to any one of the claims 1 to 12, characterized in that at least one ferromagnetic layer (13, 14, 15) is separated from the adjacent, non-magnetic layer (16, 17) by an ultra-thin, cobalt-rich, magnetic layer.

14. Sensor according to any one of the claims 1 to 13, characterized in that it has a protective layer (18) covering the stack.

15. Sensor according to any one of the claims 1 to 14, characterized in that the stack is placed on a substrate (11).

16. Sensor according to claim 15, characterized in that it has a buffer layer (12) between the stack and the substrate (11).
